Europäisches Patentamt

European Patent Office

Office européen des brevets

(11) Publication number: **0 192 390**
A2

## (12) EUROPEAN PATENT APPLICATION

(21) Application number: 86300871.0

(22) Date of filing: 10.02.86

(51) Int. Cl.⁴: **B 05 B 7/06**

(30) Priority: 19.02.85 JP 31289/85

(43) Date of publication of application:
27.08.86 Bulletin 86/35

(84) Designated Contracting States:
DE FR GB

(71) Applicant: JUNKOSHA CO. LTD.
25-25, Miyasaka 2-chome
Setagaya-ku Tokyo156(JP)

(72) Inventor: Imaizumi, Haruo
Junkosha Co. Ltd. 25-25 Miyasaka 2-chome
Setagaya-ku Tokyo(JP)

(72) Inventor: Wada, Hidetaka
Junkosha Co. Ltd. 25-25 Miyasaka 2-chome
Setagaya-ku Tokyo(JP)

(74) Representative: Taylor, Derek George et al,
Mathisen, Macara & Co. The Coach House 6-8 Swakeleys
Road
Ickenham Uxbridge UB10 8BZ(GB)

(54) Apparatus and method for surface treatment.

(57) Apparatus and a method are provided for treating surfaces of chemically inactive substances such as high molecular weight polymers, specifically the fluorocarbon polymers, so that other materials may be adhered to or plated onto the treated surface. The apparatus comprises means for supplying an inert gas through an annular opening around the nozzle of an atomizer used to spray treating chemicals onto the surface, particularly chemicals affected by oxygen or moisture, which produces an inert gas blanket surrounding the surface area being treated.

Fig.1.

EP 0 192 390 A2

Croydon Printing Company Ltd.

## APPARATUS AND METHOD FOR SURFACE TREATMENT

The invention relates to an apparatus and method for treating surfaces of chemically inactive substances such as fluorocarbon polymers so that other materials may be adhered to or plated on to the treated surface.

More particularly, the invention relates to surface treatment using a surface treatment agent which is liable to have its beneficial treatment effect degraded by the presence of oxygen or moisture in the air.

Fluoroplastic polymers are materials having good electric insulation, heat resistance and chemical resistance properties and, therefore, are used widely in various fields including, in the electrical field, a flexible printed circuit board, a flat cable or an insulating tube.

In such applications, the fluoroplastic is frequently joined to a metallic material such as iron or copper foil, or another insulating material. Because the fluoroplastic has a chemically inactive surface, although it has the above excellent characteristics, it is difficult to process when it is required to be adhered as it is or in a case where it is to be joined to another material as in a plating process.

According to the present invention there is provided apparatus for spray treating a surface of a fluorocarbon polymer or other chemically inactive substance with a treatment agent whose beneficial treating effects are decreased in the presence of air or water, said apparatus comprising a reservoir for containing said surface treatment agent, atomizing and spraying injector means having a nozzle, said injector means connected to said reservoir, means for supplying said treatment agent from said reservoir to said injector means, and inert gas supply means having a supply line for supplying inert gas from a source to a second nozzle disposed circumferentially around said injector nozzle to form an annular space between said injector nozzle and said second nozzle through which said inert gas can pass, thereby providing a blanket of inert gas surrounding the spray of treatment agent and isolating said agent from the surrounding atmosphere during treatment.

The present invention also provides a method for spray treating a surface of a fluorocarbon polymer or other chemically inactive substance with a treatment agent whose beneficial treating effects are decreased in the presence of air or water to facilitate adherence of other materials, said method comprising causing a flow of atomized treatment agent and a coaxially-surrounding flow of an inert gas to impinge on said surface so that the treatment agent at said surface is isolated by said gas from the surrounding atmosphere.

The invention will now be particularly described, by was of example, with reference to the accompanying drawings in which:-

Figure 1 is a schematic representation of apparatus according to the invention, and

Figure 2 is a front elevation of the end of the atomizer spray nozzle and the surrounding inert gas gun which forms the annulus through which inert gas is directed to surround the sprayed, atomized treatment chemical.

The apparatus comprises means for supplying an inert gas through an annular opening around the nozzle of an atomizer used to spray treating chemicals on to the surface, particularly chemicals affected by oxygen or moisture, which produces an inert gas blanket surrounding the surface area being treated.

In order to inject the surface treatment agent to surround the atomized surface treatment particles with the inert gas atmosphere, the treatment agent can be compressed and atomized from the nozzle of the injector by a separate pressure supply, for example, and at the same time the surface treatment particles can be surrounded with the inert gas supplied from the inert gas injection port formed in the vicinity of the outer circumference of the nozzle. If the compressed inert gas is used both as a medium, such as a jet pump, working the liquid which is atomized to the surface treatment agent, on the other hand, the surface treatment can be atomized and supplied together with the inert gas from the same pressurized gas source.

If an inexpensive gas such as nitrogen gas is used as the inert gas, either the surface treatment agent for the fluoroplastic having its beneficial effect decreased by the moisture in the air, as described above, or an anaerobic surface treatment agent having its effect decreased by oxidation by oxygen in the air can be applied economically and suitably without substantial decrease in the effect resulting.

As shown in the accompanying drawing the surface treating apparatus 1 includes a tank 10 providing a reservoir for containing a surface treatment agent 11, an injector means 20 connected to tank 10 via a hose 12 and comprised of a spray gun having nozzle 22 for atomizing the surface treatment agent supplied from tank 10, and an inert gas supply 30 such as a nitrogen gas bomb connected to injector means 20 via a conduit 31, and having suitable valving known in the art. The inert gas supply 30 is further connected to tank 10 via conduit 32 in order to compress the surface treatment agent 11 by means of the compressed nitrogen gas in the inert gas supply 30.

The inert gas supply 30 provides a common supply of inert gas for forcing the surface treatment agent to the injector 20 and an inert gas supply for supplying the inert gas to and through the annular opening 25 between the outer circumference of atomizer nozzle exit 22 and inner circumference of gas gun 23.

In the surface treating apparatus 1 thus constructed, the surface treatment agent 11 in the tank 10 is compressed (to about 4 kg/cm$^2$) by the nitrogen gas supplied from the inert gas supply 30 and is carried to the injector means 20 through the hose 12. The injector 20 is powered by nitrogen gas (at about 0.5 kg/cm$^2$) from the inert gas supply 30 composed of the bomb via the conduit 31 so that the surface treatment agent 11 is atomized by the pressure of the nitrogen gas when a trigger 21 of the injector 20 is pulled, and surface treatment agent is sprayed from nozzle exit 22 on to an article 40 to be treated. At this time the atomized surface treatment agent 13 is formed into a mixed mist with the nitrogen gas, which is injected by the inert gas supply means formed around the outer circumference of nozzle exit 22, and nozzle 22 is surrounded by the nitrogen gas so that the atomized agent is kept away from contact with the surrounding air until after it is applied to the article, thus having its beneficial effect blocked from being decreased by the presence of air. Because nozzle exit 22 is likewise surrounded by the nitrogen gas atmosphere while it is being used, the surface treatment agent does not chemically react at the nozzle exit 22 so that it can be continuously injected upon the surface resulting in remarkably efficient treatment.

The aforementioned embodiment is directed to apparatus for atomizing the surface treatment agent by the so-called "air spray method". Despite this fact, however, another injecting method can be adopted. Although not shown, the air spray method can be used to inject the surface treatment agent under a high pressure from a nozzle by means of a pump or the like, and at the same time an inert gas such as nitrogen gas can be injected from a separate source and around the nozzle. Then the atomized surface treatment agent can be surrounded by the inert gas so that it can likewise be efficiently applied without substantial decrease in the effect of the surface treatment agent.

As has been described hereinbefore, a surface treatment agent which is sensitive to reaction with oxygen or moisture in the surrounding air is atomized for the treatment, and surrounded by inert gas such as nitrogen gas so that the surface treating can be conducted simply and efficiently. Because the adjustment of the area to be treated is arbitrary, as distinct from a dipping method, high efficiency of surface treating can be achieved.

Because the surface treatment agent is kept away from contact with the air until after the treating is effected, a treating liquid always having a high treating efficiency and an always constant performance can be applied to provide apparatus which can provide continuous treatment of large areas.

In treating by the prior dipping process, the surface treatment agent will wet the article in excess and is always exposed to the air during the treatment, and its effect is decreased prematurely requiring it to be uneconomically replaced by a new supply when its properties are decreased. In contrast, the use of the apparatus of the present invention makes it possible not only to apply a proper amount of surface treatment agent but also to make effective use of the treatment without a substantial drop in the effect due to factors other than reaction with the article being treated, thus providing an economical surface treating apparatus.

The present invention should not be limited to the above-specified embodiment but can naturally be modified in various manners by disposing the inert gas supply means separately of the injector, by attaching the surface treatment reservoir tank to the upper or lower portion of the injector not separately of the injector thereby to supply the surface treatment by gravity or attraction, or by changing the method of injecting the surface treatment agent.

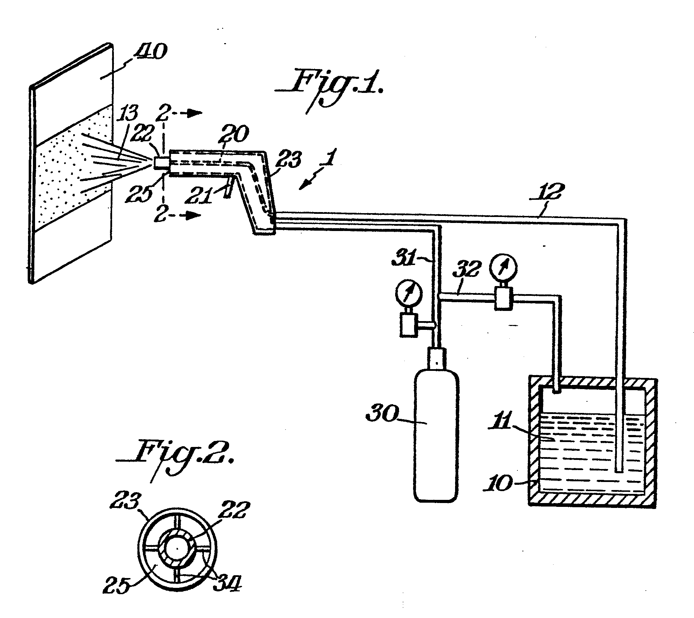

Fig. 2 shows a front elevation of the spray gun nozzle
22 and gas gun exit 23 separated by struts 34 and
having annular space 25 through which the gas exits
and surrounds the treating agent exiting nozzle 22.

## CLAIMS

1.   Apparatus for spray treating a surface of a fluorocarbon polymer or other chemically inactive substance with a treatment agent whose beneficial treating effects are decreased in the presence of air or water, said apparatus comprising a reservoir for containing sid surface treatment agent, atomizing and spraying injector means having a nozzle, said injector means connected to said reservoir, means for supplying said treatment agent from said reservoir to said injector means, and inert gas supply means having a supply line for supplying inert gas from a source to a second nozzle disposed circumferentially around said injector nozzle to form an annular space between said injector nozzle and said second nozzle through which said inert gas can pass, thereby providing a blanket of inert gas surrounding the spray of treatment agent and isolating said agent from the surrounding atmosphere during treatment.

2.   A method for spray treating a surface of a fluorocarbon polymer or other chemically inactive substance with a treatment agent whose beneficial treating effects are decresed in the presence of air or water, said method comprising:

(a) containing said surface treatment agent within a reservoir,

(b) supplying said agent from said reservoir to and through an atomizing and spraying injector means having a nozzle, and

(c) supplying an inert gas from a gas supply reservoir to and through a second nozzle disposed circumferentially around said injector nozzle so as to form an annular space between said injector nozzle and said second nozzle, thereby providing a blanket of inert gas surrounding the spray of treatment agent and isolating said agent from the surrounding atmosphere during treatment.

3. A method for spray treating a surface of a fluorocarbon polymer or other chemically inactive substance with a treatment agent whose beneficial treating effects are decreased in the presence of air or water, to facilitate adherence of other materials, said method comprising causing a flow of atomized treatment agent and a coaxially-surrounding flow of an inert gas to impinge on said surface so that the treatment agent at said surface is isolated by said gas from the surrounding atmosphere.

4.    An   article   of manufacture having a surface   of
a  fluorocarbon   polymer  or other   inactive   substance
which   has   been  treated by the   method   according   to
claim 2.

Fig.1.

Fig.2.